# EUROPEAN PATENT APPLICATION

(11) **EP 1 558 065 A2**
(43) Date of publication of application: **27.07.2005**
(21) Application number: 05075085.0
(22) Date of filing: 11.01.2005
(51) Int. Cl.: H05K 1/02, H05K 3/46

(54) **Surface mounting of components**

(30) Priority: 23.01.2004 US 763833
(71) Applicant: Delphi Technologies, Inc., Troy, MI 48007 (US)
(72) Inventor: Chengalva, Mahesh K., Kokomo, IN 46902 (US); Chengalva, Suresh K., Kokomo, IN 46902 (US); Snyder, Rick B., Kokomo, IN 46902 (US)
(74) Representative: Denton, Michael John

(57) **Abstract**

Surface mounting of components includes providing a substrate (10) that has a first surface and a second surface. A portion of the first surface is coupled to a conductive layer (20) that is patterned. A compliant layer (50) is introduced to the first surface of the substrate (10) and to the conductive layer (20). At least one aperture is formed in the compliant layer (50) which extends to the surface of the conductive layer (20). Conductive material is introduced into the aperture(s). Solder couples the surface mount component (90) to the compliant layer (50).

## Description

### Technical Field

The invention relates generally to mounting of electronic components to a substrate such as a circuit board. More specifically, the invention relates to surface mount technology.

### Background of the Invention

Typically, there are two methods to mount electronic components such as chip resistors, chip capacitors, inductors, transistors, integrated circuits, chip carriers and the like to circuit boards. In the first method, leads from electronic components extend through holes in the board. The leads are soldered inside the holes and may also be soldered on the opposite side of the board. In the second method, the electronic components are soldered to the same side of the board upon which they are mounted without penetration of the circuit board. This latter method is commonly referred to as surface mounting of electronic components.

Surface mounting of electronic components is a desirable technique because it lends itself well to process automation. One family of surface-mounted devices, referred to as "flip chips", exemplifies the process of automation. Flip chips comprise integrated circuit devices having numerous connecting traces attached to pads mounted on the underside of the device. In connection with the use of flip chips, either the circuit board or the chip is provided with small bumps or balls of solder (hereinafter referred to as "bumps" or "solder bumps") positioned in locations that correspond to the pads on the underside of each chip and on the surface of the circuit board. The chip is mounted by (a) placing it in contact with the board such that the solder bumps become sandwiched between the pads on the board and the corresponding pads on the chip; (b) heating the assembly to a point at which the solder is caused to reflow (i.e., melt); and (c) cooling the assembly. Upon cooling, the solder hardens, thereby mounting the flip chip to the board's surface.

There are at least two problems associated with the present surface mounting technology. The first problem relates to thermomechanical fatigue that occurs during thermal cycling of the surface mounted assembly. The surface mount component (e.g. flip chip), the solder, and the material forming the circuit board typically have significantly different coefficients of thermal expansion. Different coefficients of thermal expansion is problematic because as the ambient temperature varies, the surface mounted component and the circuit board expand at different rates creating a strain (i.e., thermomechanical fatigue) at the interface. If the strain exceeds the yield strength of the solder, plastic deformation occurs. Repeated temperature cycling may cause plastic deformation to accumulate resulting in the fracture of the solder joint. This in turn causes degradation of the device performance or incapacitation of the device entirely.

To minimize thermomechanical fatigue from different thermal expansions, epoxies are typically used as an underfill material that surrounds the periphery of the flip chip and occupies the space beneath the chip between the underside of the chip and the circuit board which is not occupied by solder. Epoxy provides some level of protection by forming a physical barrier that resists or reduces different thermal expansions among the components of the device. Despite the use of underfill material, a certain level of thermomechanical fatigue still exists that may cause the surface mounted device to degrade or to fail.

The second problem associated with surface mounting technology is the mechanical flexure of the circuit board during manufacturing that may affect the solder joint between the surface mounted component and the circuit board. What is needed is a method for mounting electronic components to a substrate such as a circuit board that will further minimize thermomechanical fatigue and enhance the reliability of the surface mounted component.

### Summary of the Invention

One embodiment of the invention relates to a method that includes a substrate that has a first surface and a second surface. A portion of the first surface is coupled to a conductive layer that is patterned. A compliant layer is introduced to the first surface of the substrate and to the conductive layer. At least one aperture is formed in the compliant layer which extends to the surface of the conductive layer. Conductive material is introduced into the aperture(s). Solder is coupled to the surface mount component and to the substrate. The surface mount component is coupled to the compliant layer. Additional features, embodiments, and benefits will be evident in view of the figures and detailed description presented herein.

### Brief Description of the Drawings

The present invention will now be described, by way of example, with reference to the accompanying drawings, in which:

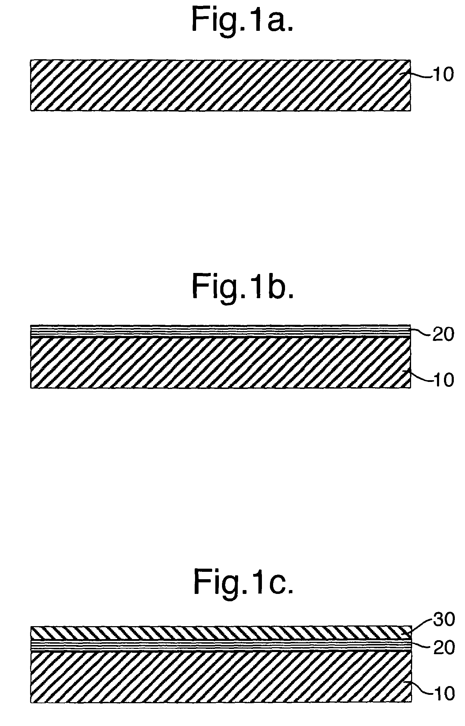

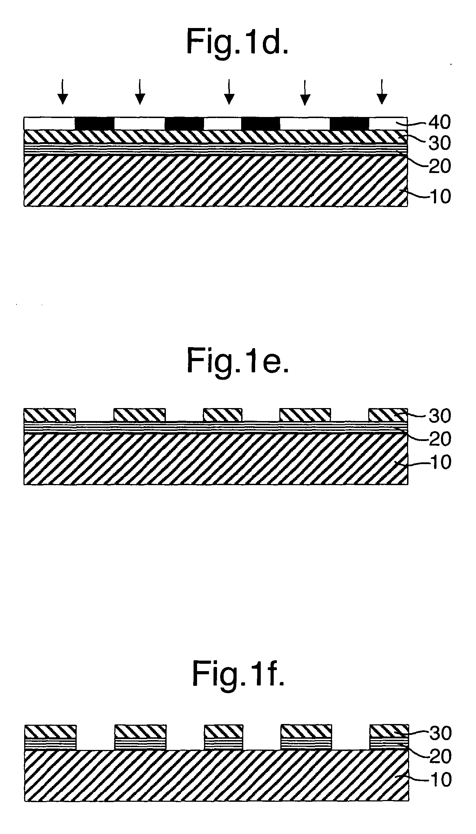

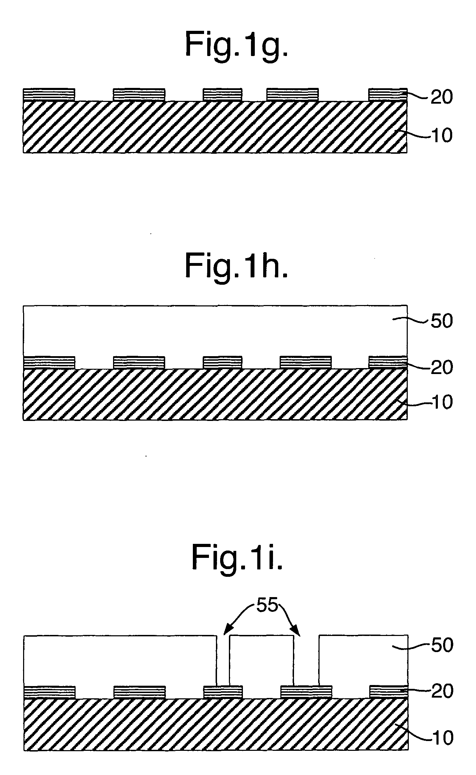

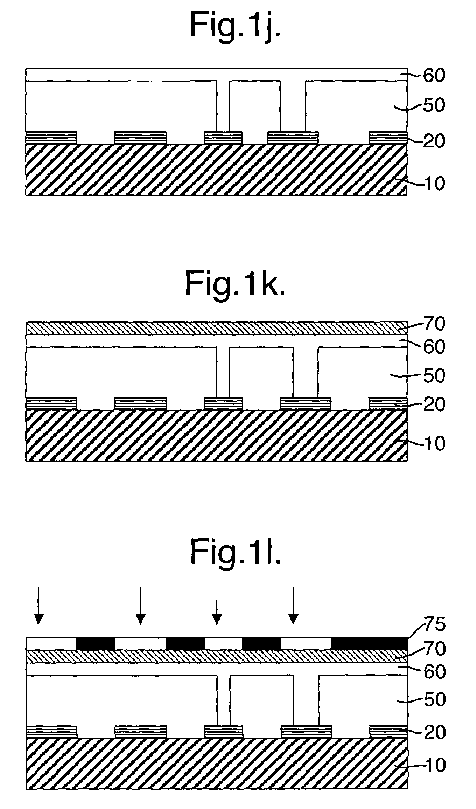

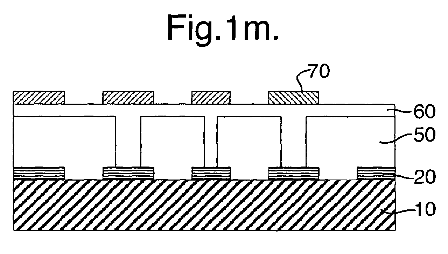

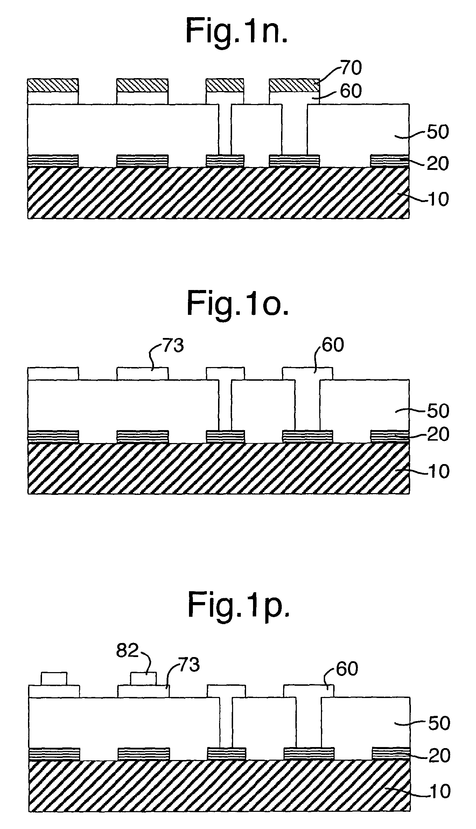

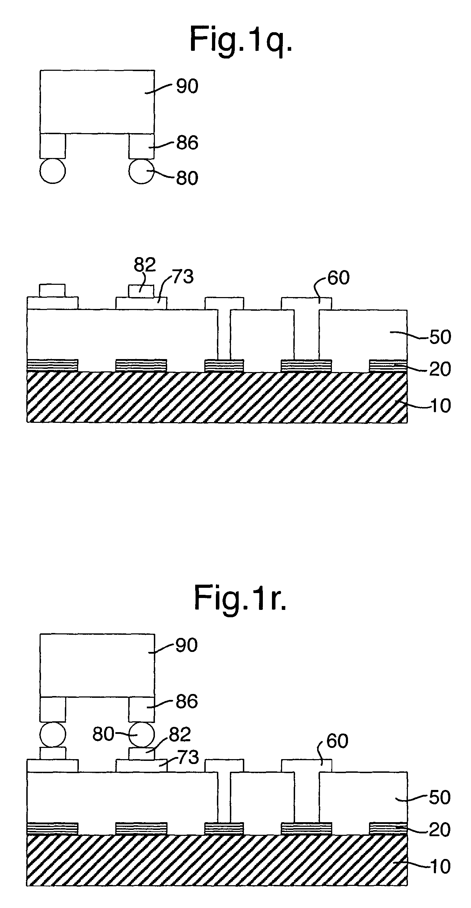

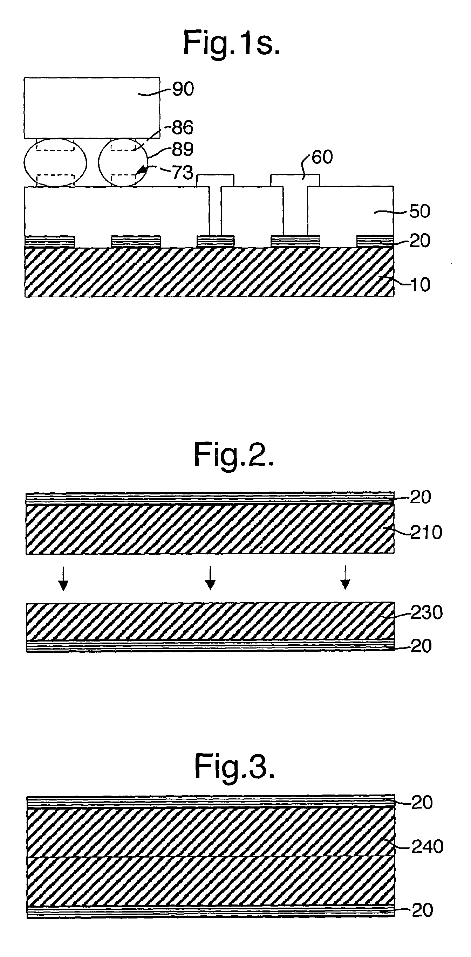

Figure 1 a is a cross-sectional view of a substrate in accordance with one embodiment of the invention;
Figure 1b is a cross-sectional view of the substrate of Figure 1a and a conductive layer coupled thereto in accordance with one embodiment of the invention;
Figure 1c is a cross-sectional view of the device in Figure 1b in which a first resist layer is introduced over the conductive layer in accordance with one embodiment of the invention;
Figure 1d is a cross-sectional view of the device in Figure 1c in which a first mask covers the first resist layer in accordance with one embodiment of the invention;
Figure I e is a cross-sectional view of the device in Figure 1d in which the unexposed areas of the first resist layer are removed in accordance with one embodiment of the invention;
Figure If is a cross-sectional view of the device in Figure I e in which a portion of the conductive layer is removed in accordance with one embodiment of the invention;
Figure 1g is a cross-sectional view of the device in Figure If in which the exposed portion of the first resist layer is removed in accordance with one embodiment of the invention;
Figure 1h is a cross-sectional view of the device in Figure 1g in which a compliant layer is introduced over the device in accordance with one embodiment of the invention;
Figure 1i is a cross-sectional view of the device in Figure 1h in which apertures are formed in the device in accordance with one embodiment of the invention;
Figure 1j is a cross-sectional view of the device in Figure 1i in which a conductive material is introduced over the device in accordance with one embodiment of the invention;
Figure 1k is a cross-sectional view of the device in Figure 1j in which a second resist layer is introduced over the device in accordance with one embodiment of the invention;
Figure 11 is a cross-sectional view of the device in Figure 1k in which a second mask is placed over the second resist layer in accordance with one embodiment of the invention;
Figure 1m is a cross-sectional view of the device in Figure 11 in which the unexposed portions of the second resist layer is removed in accordance with one embodiment of the invention;
Figure In is a cross-sectional view of the device in Figure 1m in which the conductive material layer is etched in accordance with one embodiment of the invention;
Figure 1o is a cross-sectional view of the device in Figure In in which the remaining portions of the second resist layer is removed in accordance with one embodiment of the invention;
Figure 1p is a cross-sectional view of the device in Figure 1o in which solder bumps are placed onto the surface of the substrate in accordance with one embodiment of the invention;
Figure 1q is a cross-sectional view of the device in Figure 1p in which a surface mount component is positioned over the compliant layer in accordance with one embodiment of the invention;
Figure 1r is a cross-sectional view of the device in Figure 1q in which a surface mount component is coupled to the compliant layer in accordance with one embodiment of the invention;
Figure 1s is a cross-sectional view of the device in Figure 1r in which a joint is formed between the surface mount component and to the compliant layer in accordance with one embodiment of the invention; Figure 2 illustrates a cross-sectional view of a first substrate and a second substrate in accordance with one embodiment of the invention;
Figure 3 illustrates a cross-sectional view of a first substrate and a second substrate coupled together in accordance with one embodiment of the invention;

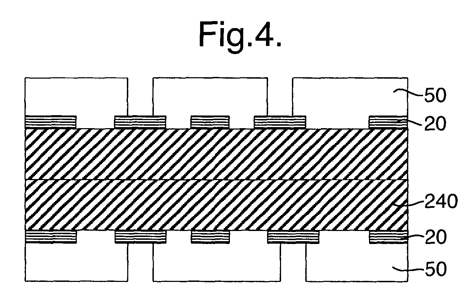

Figure 4 illustrates a cross-sectional view of a device that is formed after implementing techniques of the invention; and

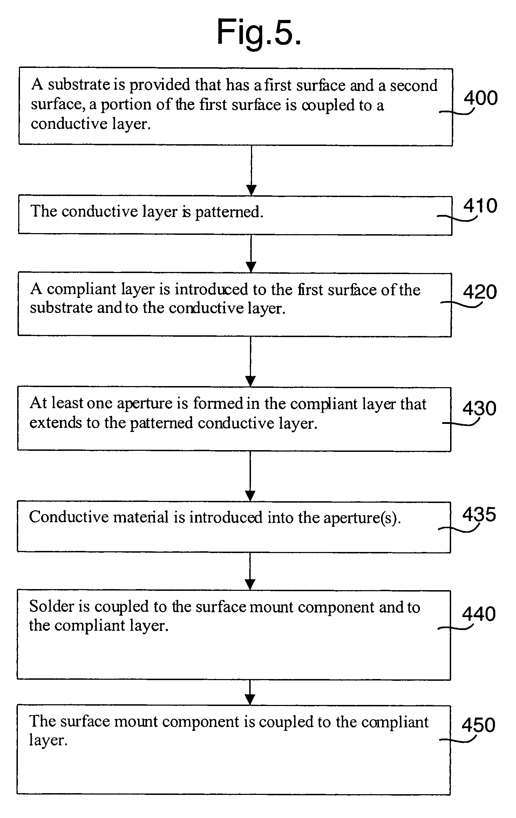

Figure 5 is a flow diagram showing one method in accordance with one embodiment of the invention.

### Description of the Preferred Embodiment

By implementing techniques of the invention, thermomechanical fatigue that may occur in the solder joint of a surface mounted component is decreased and the reliability of the surface mounted assembly is enhanced. This is accomplished, in part, by placing a compliant layer that has interconnect (or routing traces) between the surface mounted component, the solder, and the circuit board as shown in Figure 1 s and described in the accompanying text. Briefly described below are several embodiments of the invention.

In one embodiment, a method includes providing a substrate that has a first surface and a second surface. A portion of the first surface is coupled to a conductive layer which is patterned. A compliant layer is then introduced over the first surface of the substrate and to the conductive layer. At least one aperture is formed in the compliant layer which extends to the surface of the conductive layer. Conductive material is introduced into the aperture(s). Thereafter, solder is coupled to the surface mount component and to the compliant layer. The surface mount component is then coupled to the compliant layer.

In yet another embodiment, a method includes coupling a copper layer to the substrate. The copper layer is patterned. A compliant layer is then applied to the substrate and to the patterned copper layer. Apertures (or vias) are formed in the compliant layer using, for example, photoablation. A metal such as electroless copper is introduced into the apertures and the compliant layer. The metal layer is patterned. Solder is coupled to a surface mount component and to the compliant layer. The surface mount component is coupled to the compliant layer.

In yet another embodiment, an apparatus includes a substrate that has a first surface and a second surface. A portion of the first surface is coupled to a patterned conductive layer. A compliant layer is then coupled to the first surface of the substrate and to the patterned conductive layer. An interconnect is coupled to the patterned conductive layer and to the compliant layer. Solder is coupled to a surface mount component and to the compliant layer. The surface mount component is then coupled to the compliant layer.

In the discussion that follows, Figures 1a-1s illustrate one method of reducing shear strain in the solder after electronic components have been surface mounted to a substrate such as a circuit board; Figures 2-4 illustrate a cross-sectional view of the formation of a six layer substrate in accordance with one embodiment of the invention; and Figure 5 is a flow diagram of another embodiment of the invention.

Figure 1a illustrates a cross-sectional view of substrate 10. Substrate 10 is defined as the foundation or base upon which something is added, introduced, coupled, or applied thereto. Substrate includes a circuit board, a chip carrier, another semiconductor device, a metal lead frame or other like components.

It will be appreciated that although Figures 1a-1s show operations occurring to one side of substrate 10, the same or similar operations may be applied to both sides of substrate 10. An example of operations applied to both sides of a substrate is the formation of a six layer substrate as is shown in Figures 2-4.

Given this brief description of how operations may be applied to substrate 10, the discussion now turns to the details of each operation. Figure 1b illustrates a cross-sectional view of conductive layer 20 coupled to substrate 10. Conductive layer 20 may be a pure metal, an alloy, or other suitable material. In one embodiment, conductive layer 20 comprises copper. Figures 1c through If illustrate one method of forming a pattern in conductive layer 20. Figure I shows a cross-sectional view of first resist layer 30 introduced over conductive layer 20. Typically, a resist is a thin organic polymer layer that undergoes a chemical reaction after the resist is exposed to energetic particles such as electrons or photons. After selective exposure through a mask, the resist is developed in a chemical solution in which a portion of the resist is removed in order to create a pattern in the resist. In the embodiment described and shown in Figure 1c, first resist layer 30 is a negative photoresist. In another embodiment, a positive photoresist may be used.

Figure I d shows a cross-sectional view of first mask 40 placed over first resist layer 30. First mask 40 allows ultraviolet rays to contact some areas of first resist layer 30 while preventing other areas of first resist layer 30 from receiving ultraviolet light. Figure 1e shows that the unexposed resist is removed (or etched) from substrate 10 using etchants such as ferric chloride, ammonical copper or other like materials. Figure 1 f shows a portion of conductive layer 20 is etched. Figure 1g illustrates the device shown in Figure I f in which the second portion of first resist layer 30, which was exposed to the ultraviolet light, is removed. Figures 1a through I g show a process that forms a patterned conductive layer 20.

Figure 1h illustrates compliant layer 50 is introduced over the device shown in Figure 1g. Compliant layer 50, which covers substrate 10 and patterned conductive layer 20, may be applied with a roller, a device to spray the compliant material, a dry film lamination operation, or other suitable method.

Parameters for creating an optimal compliant layer include the thickness of the compliant layer, the "softness" or elastic modulus of the compliant layer, and the coefficient of thermal expansion of the compliant layer. Numerous combinations exist with respect to selecting the proper thickness, elastic modulus, and the coefficient of thermal expansion to attain a specified reliability goal for an electronic component. The optimal combination of the three parameters for designing and creating an electronic assembly may be determined using a computer program capable of performing Finite Element analyses. In one embodiment, a designer of a surface mounted assembly may input a specific reliability goal and a range for one of the parameters, such as the thickness of the compliant layer. After execution of the computer program, recommended values for the two remaining parameters are presented to the designer on, for example, a graphical user interface, a printer or other like output device coupled to a computer. In another embodiment, the designer may input one or more of the parameters and then the computer program determines whether the reliability goal of the electronic component has been met. Given this general process of designing a surface mounted electronic assembly, the three parameters used in the design process are examined below followed by an example of a substrate that is ten times more reliable than conventional substrates.

Table 1 shows the elastic modulus for certain materials. Techniques of the invention generally require an elastic modulus be in the range of about 0.5 to 100 megapascal (MPa) for elastomer films and 500 to about 2000 MPa for polyimide films. It will be appreciated by one skilled in the art that a variety of materials that possess elastic modulus below 0.5 MPa or between 100-500 MPa may also be used to implement techniques of the invention. In contrast, FR4 cannot be used as a compliant layer.

**Table 1**

| Elastic modulus for specified materials | |
|---|---|
| **Type of Material** | **Typical Elastic Modulus Values (megapascal (MPa))** |
| Elastomer Films | 0.5 - 100 |
| Various materials | 100-500 |
| Polyimide Films | 500 - 2000 |
| Polymer Composites | 6000 - 20,000 |
| FR4 | 15,000 - 28,000 |

Numerous types of elastomer films and polyimide films are commercially available such as a special grade silicone from Dow located in Midland, Michigan or Kapton films available from DuPont located in Wilmington, Delaware.

In addition to the elastic modulus, the thickness of the compliant layer and the thermal expansion coefficients associated with a material are also considered when designing a suitable substrate. While the thickness of the compliant layer may have an almost unlimited range, in practice, a range from about 0.01 to about 1 millimeter of thickness may be used. Finally, the coefficient of thermal expansion of the compliant layer may be unlimited but generally 180 parts per million/°C has been successfully used in one example, as discussed below. While ranges have been provided for three parameters used in selecting the compliant layer, it will be appreciated that a particular elastic modulus may not be used with a particular thickness of a compliant layer 50 to satisfy a reliability goal. Essentially, the designer of the surface mounted assembly must determine the proper combination of the three parameters by using, for example, a computer program that includes Finite Element analysis. This Finite Element analysis computer program predicts the reliability of a surface mounted assembly.

In one embodiment, the compliant layer is about 0.25 millimeters (mm) with a substrate having a thickness of about 0.78 mm. The elastic modulus used in this embodiment was about 75 MPa whereas the thermal expansion was about 180 ppm/°C. This device increases the reliability over conventional devices such as circuit boards by about ten fold.

Given the process used to determine compliant layer 50 and one example of parameters used to form a substrate, the discussion now turns to the operations performed on the compliant layer 50. Figures 1i through In illustrate cross-sectional views of the formation of interconnect (or routing traces) in compliant layer 50. Specifically, Figure 1i illustrates the device of Figure 1h in which apertures 55 are formed in compliant layer 50 that extend from about the top of compliant layer 50 to the surface of conductive layer 20. Apertures (or vias) 55 may be created using photoablation, plasma, carbon dioxide laser, controlled depth drilling or other suitable method.

Figure 1j illustrates conductive material 60 such as a metal (e.g. electroless copper), alloy, or other suitable material is introduced into apertures 55 and over the surface of compliant layer 50 of the device shown in Figure 1i. Compliant layer 50, which has interconnect (or traces) extending from a surface of the patterned conductive layer 20 to about the top surface of compliant layer 50, reduces thermomechanical fatigue that may occur. This is accomplished by compliant layer 50 absorbing the shear strain that results during the thermal cycling process of the surface mounted assembly. The configuration of compliant layer 50 with the interconnect formed therein may also reduce strain that may occur at the solder joint.

Figure 1k illustrates second resist layer 70 introduced over conductive material 60 of the device shown in Figure 1j. In this embodiment, second resist layer 70 is a negative photoresist. In another embodiment, a positive photoresist may be used.

Figure 11 illustrates second mask 75 placed over second resist layer 70 of the device shown in Figure 1k. Second mask 75 is exposed to ultraviolet light but only a portion of second resist layer 70 receives the ultraviolet light. Figure 1m illustrates the device shown in Figure 11 in which a first portion of second resist 70, the unexposed resist, is removed using the same or similar etchants described above. Figure In illustrates the device shown in Figure 1m in which a portion of conductive material 60 is etched or removed. The etchant selected depends upon conductive material 60. In one embodiment, conductive material 60 comprises copper. Accordingly, ammonical copper is one etchant that may be used. Figure 1o illustrates the device shown in Figure In in which a second portion of second resist layer 70, the resist exposed to ultraviolet light, is removed. In one embodiment, contact pads 73 are fully formed after removing second resist layer 70. Figure 1p illustrates the device shown in Figure 1o in which solder paste 82 is placed on contact pads 73.

Figure I q illustrates surface mount component 90 prior to being coupled to the device of Figure 1p. Surface mount component 90 includes electronic components or other components mounted on compliant layer 50 using surface mount technology. Examples of a surface mount component include chip resistors, chip capacitors, inductors, transistors, integrated circuits, chip carriers and the like. While surface mount component 90 shows two solder bumps 80 located on contact pads 86 of the underside of surface mount component 90, one skilled in the art will appreciate that numerous solder bumps may be used.

The solder in solder bumps 80 or in solder paste 82 may be a metal, alloy, or other suitable material. Solder may also include or exclude lead. Alternatively, conductive adhesive joints may be used in place of solder joints. Conductive adhesive joints also experience a reduction in thermomechanical strain due to the use of a compliant layer interspersed with interconnect. Conductive adhesive joints are a resin based system that is highly filled with silver particles. In one example, the conductive adhesive may contain 70-85% by weight of silver particles. The conductive adhesive may be applied as a paste to the substrate where the surface mounted component may be attached. After the conductive adhesive contacts the surface mounted component, the conductive adhesive is cured using conventional techniques to form the integrated circuit interconnect.

It will be appreciated that numerous types of materials may be considered a conductive adhesive. Examples of conductive adhesives include isotropic conductive adhesive, anisotropic conductive adhesive or other suitable material. With respect to the anisotropic conductive adhesive, the adhesive resin may be filled with conductive spheres (3 - 10µm diameter). Conductive spheres may include nickel/gold plated polymer spheres, solid nickel particles or other like material.

Specific commercial examples of conductive adhesives include products such as Namics XH9626 produced by Namics Technologies, Inc. located in Santa Clara, California; Loctite 3889 produced by Henkel Loctite Corporation located in Rocky Hill, Connecticut; Emerson & Cuming LC-66 produced by Emerson & Cuming located in Canton, Michigan and Dow Coming DC3-6043 produced by Dow Coming Corporation located in Midland, Michigan.

Figure 1r illustrates the device shown in Figure 1q in which solder bumps 80, located on contact pads 86 at the underside of surface mount component 90, is directly coupled to solder paste 82 on contact pads 73. Figure 1s illustrates the device of Figure 1r in which surface mounted component 90 has undergone a solder reflow process thereby forming solder joint 89 between surface mount component 90 and compliant layer 50. Ghost lines are used to show contact pads 73 and 86 may be fully embedded in solder joint 89. After the solder reflow process, conventional techniques are used to further process surfaced mount component 90 and the substrate.

Figures 2-4 illustrate cross-sectional views of the formation of a six layer substrate in accordance with one embodiment of the invention. In particular, Figure 2 discloses a cross-sectional view of a first substrate 210 and a second substrate 230 prior to being coupled together through, for example, lamination. Figure 3 discloses a cross-sectional view of a third substrate 240 formed by coupling the first and second substrates together. Figure 4 shows a cross-sectional view of third substrate 240 after operations disclosed in Figures 1a through 1s have been applied to both sides of substrate three 240. As shown here, the resultant structure comprises six layers. These six layers assist in reducing the mechanical flexure that is experienced by typical substrates such as a circuit board.

Figure 5 is a flow diagram of another method in accordance with one embodiment of the invention. At operation 400, a substrate is provided that has a first surface and a second surface, a portion of the first surface is coupled to a conductive layer. At operation 410, the conductive layer is patterned. At operation 420, a compliant layer is introduced to the first surface of the substrate and to the conductive layer. At operation 430, one aperture is formed in the compliant layer that extends to the patterned copper layer. At operation 435, conductive material is introduced into the aperture(s). At operation 440, solder is coupled to the surface mount component and to the compliant layer. Solder may be a metal, alloy, or other suitable material. Moreover, the solder may include or exclude lead. At operation 450, the surface mount component is coupled to the compliant layer.

It will be appreciated that more or fewer processes may be incorporated into the method illustrated in Figure 5 without departing from the scope of the invention. Additionally, no particular order is implied by the arrangement of blocks shown and described herein. It will also be appreciated that the method described in conjunction with Figure 5 may be embodied in machine-executable instructions, e.g., software. The instructions can be used to cause a general-purpose or special-purpose processor that is programmed with the instructions to perform the operations described. Alternatively, the operations might be performed by specific hardware components that contain hard-wired logic for performing the operations, or by any combination of programmed computer components and custom hardware components. The methods may be provided as a computer program product that may include a machine-readable medium having stored thereon instructions which may be used to program a computer (or other electronic devices) to perform the methods. For the purposes of this specification, the terms "machine-readable medium" may be taken to include any medium that is capable of storing or encoding a sequence of instructions for execution by the machine and that cause the machine to perform any one of the methodologies of the present invention. The term "machine-readable medium" includes, but is not be limited to, solid-state memories, optical and magnetic disks, and carrier wave signals. Furthermore, it is common in the art to speak of software, in one form or another (e.g., program, procedure, process, application, module, logic ... etc.), as taking an action or causing a result. Such expressions are merely a shorthand way of saying that execution of the software by a computer causes the processor of the computer to perform an action or a produce a result.

In the preceding detailed description, the invention is described with reference to specific embodiments thereof. It will, however, be evident that various modifications and changes may be made thereto without departing from the broader spirit and scope of the invention as set forth in the claims. The specification and drawings are, accordingly, to be regarded in an illustrative rather than a restrictive sense.

## Claims

1. A method comprising:
providing a substrate (10) having a first surface and a second surface, a portion of the first surface is coupled to a conductive layer (20);
patterning the conductive layer (20);
introducing a compliant layer (50) to the first surface of the substrate (10) and to the conductive layer (20);
forming at least one aperture in the compliant layer (50) which extends to a surface of the conductive layer (20);
introducing a conductive material (20) into the at least one aperture; coupling solder to the surface mount component (90) and to the compliant layer (50); and
coupling the surface mount component (90) to the compliant layer (50).

2. The method of claim 1, wherein the compliant layer comprises one of an elastomer and a polyimide.

3. The method of claim 2, further comprising:
selecting the compliant layer (50) based upon an elastic modulus, a thickness, and a coefficient of thermal expansion associated with the compliant layer (50).

4. The method of claim 2, wherein the compliant layer (50) is selected from elastomers having an elastic modulus from about 0.5 megapascal (MPa) to about 100MPa.

5. The method of claim 2, wherein the compliant layer (50) is selected from an elastic modulus of a polyimide which ranges from about 500 to about 2,000MPa.

6. The method of claim 1, wherein the conductive layer (20) comprises copper.

7. The method of claim 1, wherein a thickness of the compliant layer (50) ranges from about 0.01 millimeters (mm) to about 1 mm.

8. A method comprising:
providing a substrate (10);
coupling a copper layer to the substrate (10);
patterning the copper layer;
applying a compliant layer (50) to the substrate (10) and to the patterned copper layer;
forming apertures in the compliant layer (50);
introducing a metal into the apertures of the compliant layer (50); patterning the metal;
coupling solder to the surface mount component (90) and to the compliant layer (50); and
coupling the surface mount component to the compliant layer (50).

9. The method of claim 8, wherein an elastic modulus of the compliant layer (50) ranges from about 0.5MPa to about 2000MPa.

10. The method of claim 8, wherein the compliant layer (50) comprises one of an elastomer and a polyimide.

11. The method of claim 8, wherein a thickness of the compliant layer (50) ranges from about 0.01 millimeters (mm) to about 1 mm.

12. An apparatus comprising:
a substrate (10) having a first surface and a second surface, a portion of the first surface coupled to a patterned conductive layer (20);
a compliant layer (50) coupled to the first surface of the substrate (10) and to the conductive layer (20);
an interconnect coupled to the compliant layer (50) and to the conductive layer (20);
solder coupled to a surface mount component (90) and to the compliant layer (50); and
the surface mount component (90) coupled to the compliant layer (50).

13. The method of claim 12, wherein an elastic modulus of the compliant layer (50) ranges from about 0.5 megapascal (MPa) to about 2000MPa.

14. The apparatus of claim 12, wherein the compliant layer (50) comprises one of an elastomer and a polyimide.

15. The apparatus of claim 13, wherein a thickness of the compliant layer (50) ranges from about 0.01 millimeters (mm) to about 1 mm.

16. An article comprising:
a storage medium including instructions stored thereon which when executed cause a digital system to perform a method including:
providing a substrate (10) having a first surface and a second surface, a portion of the first surface is coupled to a conductive layer (20);
patterning the conductive layer (20);
introducing a compliant layer (50) to the first surface of the substrate (10) and to the conductive layer (20);
forming at least one aperture in the compliant layer (50) which extends to a surface of the conductive layer (20);
introducing a conductive material (20) into the at least one aperture;
coupling solder to the surface mount component (90) and to the compliant layer (50); and
coupling the surface mount component (90) to the compliant layer (50).

17. A machine readable storage media containing executable program instructions which when executed cause a digital processing system to perform a method comprising:
providing a substrate (10) having a first surface and a second surface, a portion of the first surface is coupled to a conductive layer (20);
patterning the conductive layer (20);
introducing a compliant layer (50)to the first surface of the substrate and to the conductive layer (20);
forming at least one aperture in the compliant layer (50)which extends to a surface of the conductive layer (20);
introducing a conductive material into the at least one aperture;
coupling solder to the surface mount component (90) and to the compliant layer (50); and
coupling the surface mount component (90) to the compliant layer (50).

18. A method comprising:
providing a substrate (10) having a first surface and a second surface, a portion of the first surface is coupled to a conductive layer (20);
patterning the conductive layer (20);
introducing a compliant layer (50) to the first surface of the substrate (10) and to the conductive layer (20);
forming at least one aperture in the compliant layer (50) which extends to a surface of the conductive layer (20);
introducing a conductive material into the at least one aperture; coupling a conductive adhesive to the surface mount component and to the compliant layer; and
coupling the surface mount component (90) to the compliant layer (50).
